# EUROPÄISCHE PATENTSCHRIFT

(11) **EP 4 639 064 B1**
(45) Veröffentlichungstag und Bekanntmachung des Hinweises auf die Patenterteilung: **22.07.2026**
(21) Anmeldenummer: 23834123.4
(22) Anmeldetag: 19.12.2023
(51) Int. Cl.: F28D 15/00, F28D 21/00, H10W 40/47, H10W 70/02

(54) **VORRICHTUNG, SYSTEM UND VERFAHREN ZUM KÜHLEN EINES PROZESSORS**
APPARATUS, SYSTEM AND METHOD FOR COOLING A PROCESSOR
DISPOSITIF, SYSTÈME ET PROCÉDÉ DE REFROIDISSEMENT D'UN PROCESSEUR

(30) Priorität: 23.12.2022 EP 22216338
(43) Veröffentlichungstag der Anmeldung: 29.10.2025
(73) Patentinhaber: TechN GmbH, 12099 Berlin (DE)
(72) Erfinder: KOHL, Nikolaus, 10999 Berlin (DE)
(74) Vertreter: Pfenning, Meinig & Partner mbB
(86) Internationale Anmeldenummer: PCT/EP2023/086568
(87) Internationale Veröffentlichungsnummer: WO 2024/133217

(56) Entgegenhaltungen:
- WO-A2-2007/006590
- CN-U- 213 659 402
- US-A1- 2012 211 199
- US-A1- 2018 100 710
- US-A1- 2019 101 341

## Beschreibung

Die vorliegende Erfindung betrifft einen Kühler für einen Prozessor, insbesondere für eine CPU oder eine GPU, sowie ein System zum Kühlen eines Prozessors und ein Verfahren zum Kühlen eines Prozessors.

Beim Betreiben elektronischer Komponenten, insbesondere von Prozessoren, wird Abwärme produziert, die zu unerwünschten Temperaturerhöhungen der Komponente führen kann. Um einer derartigen Temperaturerhöhung entgegen zu wirken, können geeignete Kühlsysteme genutzt werden, die die Abwärme der elektrischen Komponente abführen. Aus dem Stand der Technik sind fluidgekühlte Kühlsysteme bekannt, die eine Abfuhr der Abwärme eines Prozessors mittels eines Fluids ermöglichen. Der Prozessor wird dazu in thermischen Kontakt mit einem Kühler des fluidgekühlten Kühlsystems gebracht, sodass dieser die Abwärme des Prozessors aufnehmen kann. Der Kühler selbst wird beispielsweise über eine Kühlflüssigkeit (beispielsweise Wasser) rückgekühlt, die durch einen Kühlkanal innerhalb des Kühlkörpers geleitet wird. Eine effiziente Abfuhr der Abwärme kann ermöglicht werden, indem ein Wärmeleitwiderstand, der zwischen Prozessor und Kühlflüssigkeit auftritt, klein gehalten wird. Eine optimale Wärmeabfuhr kann typischerweise erreicht werden, wenn die Kühlflüssigkeit an jedem Punkt des Kühlkanals in Kontakt mit dem Kühlkörper ist.

Fluidgekühlte Kühlsysteme wie flüssigkeitsgekühlte Kühlsysteme können als geschlossenes System ausgebildet sein. Derartige Kühlsysteme können eine Pumpe, mit der Kühlflüssigkeit durch einen Kühlkreislauf gepumpt werden kann, und einen Radiator, der der Abgabe der durch die Kühlflüssigkeit abgeführten Wärmeenergie dient, aufweisen. Beim Betrieb fluidgekühlter Kühlsysteme kommt es häufig vor, dass Luft und/oder Gas von der Kühlflüssigkeit mitgeführt wird und/oder sich im Lauf der Betriebs- und/oder Standzeit des Kühlsystems von der Flüssigkeit trennt, also abscheidet. Beim Bereitstellen eines derartigen fluidgekühlten Kühlsystems ist es zudem nur schwer vermeidbar, dass Luft und/oder ein Gas im Kühlflüssigkeitskreislauf, zu dem der Kühlkanal gehört, eingeschlossen wird. Unabhängig davon kann ein Gas/oder Luft auch an undichten Stellen des Kühlsystems und/oder über Diffusion in den Kühlkreislauf eindringen. Wenn nachfolgend von Gas oder abgeschiedenem Gas gesprochen wird, ist damit Gas und/oder Luft gemeint, das sich im Kühlkreislauf befindet, unabhängig davon, auf welche Weise es in den Kühlkreislauf geraten ist und um welche Art von Gas es sich handelt.

Das abgeschiedene Gas hat typischerweise einen geringeren Wärmeleitkoeffizienten als die Kühlflüssigkeit und kann daher dazu beitragen, den Wärmeleitwiderstand zwischen Prozessor und Kühlflüssigkeit zu erhöhen. Unabhängig davon kann das Gas unerwünschte Geräusche erzeugen, die Förderleistung der Pumpe mindern, oder zu deren Ausfall führen, wenn sich beispielsweise große Mengen Gas in der Pumpe ansammeln. Ein Ansammeln von Gas in gewissen Bereichen des Kühlkreislaufs sollte also für einen optimalen Betrieb des Kühlsystems vermieden werden.

Das Gas ist typischerweise leichter als die Kühlflüssigkeit und wird entgegen der Richtung der Schwerkraft, also nach oben, abgeschieden. In fluidgekühlten Systemen ist deshalb häufig vorgesehen, dass die Komponenten des Systems nur in bestimmten Höhenlagen zueinander und/oder Orientierungen zur Schwerkraft angeordnet werden. Dadurch soll eine Ansammlung des Gases in Bereichen verhindert werden, die sich nachteilig auf den Betreib eines derartigen Kühlsystems auswirken kann.

Fluidgekühlte Kühlsysteme des Stands der Technik ermöglichen insbesondere dann eine effiziente Kühlung eines Prozessors, wenn sie in einer bestimmten Einbaulage betrieben werden, d.h. wenn sie eine bestimmte Orientierung zur Richtung der Schwerkraft aufweisen. Konkret bedeutet das, dass der Prozessor, insbesondere eine CPU oder eine GPU, meist nur in einer einzigen bestimmten Einbaulage, die in der Regel vertikal oder horizontal ist, betrieben werden kann.

Kühler aus dem Stand der Technik sind zum Beispiel aus den folgenden Veröffentlichungen bekannt: WO 2007/006590 A2, die einen Kühler für einen Prozessor gemäß dem Oberbegriff des Anspruchs 1 offenbart, CN 213 659 402 U, US 2019/101341 A1, US 2018/100710 A1 und US 2012/211199 A1.

Aufgabe der vorliegenden Erfindung ist es einen Kühler, ein Kühlsystem, sowie ein Verfahren zum Betreiben eines Kühlers bereitzustellen, welche die vorstehend genannten Probleme zumindest teilweise lösen.

Die Aufgabe wird durch einen Kühler, das Kühlsystem, sowie das Verfahren nach den unabhängigen Ansprüchen gelöst. Vorteilhafte Weiterbildungen der Erfindung sind durch die abhängigen Ansprüche angegeben.

Der Erfindung liegt die Idee zu Grunde, Volumina innerhalb des Kühlers vorzusehen, die sich in zumindest zwei Einbaulagen des Kühlers zur Aufnahme und Speicherung der abgeschiedenen Gase eignen und dabei so angeordnet sind, dass sie den Wärmeleitwiderstand zwischen Prozessor und Kühlflüssigkeit nicht beeinträchtigen. Dabei soll insbesondere ein Ansammeln des von der Kühlflüssigkeit abgeschiedenen Gases in einem Bereich, der innerhalb des Kühlers auf direkter Linie zwischen Prozessor und Kühlflüssigkeit liegt, vermieden werden.

Ein erfindungsgemäßer Kühler für einen Prozessor, insbesondere für eine CPU oder eine GPU, weist einen Kühlkörper mit einer Außenkühlfläche zum Kühlen des Prozessors auf. Die Außenkühlfläche ist eine Teilfläche der Außenfläche des Kühlkörpers, die dazu vorgesehen ist, Wärme aufzunehmen, insbesondere die Abwärme eines Prozessors. Der Kühler kann optional zumindest eine weitere Kühlfläche aufweisen, die zum Kühlen zumindest einer weiteren elektronischen Komponente, eines weiteren Prozessors, insbesondere eines CPU oder GPU, und/oder zumindest eines wärmeabgebenden oder wärmeproduzierenden Bereichs einer Platine ausgestaltet ist. Unter einer elektronischen Komponente kann dabei jedes elektronische Element verstanden werden, das bei Betrieb Abwärme produziert, insbesondere können darunter elektronische Schaltungen, integrierte Schaltkreise (ICs) oder andere programmierbare oder nicht-programmierbare Rechenwerke verstanden werden.

Es kann vorgesehen sein, dass die Form des Kühlkörpers an den zu kühlenden Prozessor angepasst ist. Der Kühlkörper kann in manchen Ausführungsformen Materialien die eine hohe Wärmeleitfähigkeit aufweisen, insbesondere zumindest teilweise Aluminium oder Kupfer aufweisen. Unabhängig davon kann der Kühlkörper oder Teile des Kühlkörpers beispielsweise in einem Spritzguss-, Druckguss- oder 3D Druckverfahren hergestellt werden. In einer Ausgestaltungsform des Kühlkörpers kann dieser Haltemittel aufweisen, mit denen der Kühlkörper beispielsweise in einem Gehäuse, insbesondere in einem Computergehäuse, gehaltert werden kann. In einer optionalen Ausgestaltung des Kühlkörpers kann der Kühlkörper Befestigungsmittel für Sensoren aufweisen deren Signale zur Steuerung und/oder für Steuerungsmittel eines Kühlkreislaufs verwendet werden können.

Die Außenkühlfläche kann vorteilhafterweise so ausgebildet sein, dass sie an die Geometrie des Prozessors angepasst ist, insbesondere an eine Teilfläche des Prozessors, die zum Abführen der vom Prozessor generierten Abwärme ausgebildet ist. Unabhängig davon kann die Oberfläche der Außenkühlfläche teilweise oder vollständig durch Beschichtungen oder Oberflächenbearbeitungsverfahren derart funktionalisiert werden, dass ihr Wärmeübertragungskoeffizient erhöht wird. Zu Ausgleichen von Toleranzen kann zwischen dem Prozessor und der Außenkühlfläche eine wärmeleitfähige Paste vorgesehen sein.

Weiter weist der Kühler einen Kanal auf, der durch den Kühlkörper verläuft und zum Durchleiten einer Kühlflüssigkeit ausgebildet ist. Kühlflüssigkeit kann also durch einen Einlass in den Kanal einströmen und durch einen Auslass aus dem Kanal herausströmen. Ein Wärmeaustausch zwischen Kühlkörper und Kühlflüssigkeit kann potentiell an jeder Grenzfläche zwischen Kanal und Kühlkörper, die im Folgenden als Kanalwand bezeichnet wird, stattfinden. Der Verlauf des Kanals durch den Kühlkörper, also der Pfad entlang welchem sich der Kanal erstreckt, kann an die Geometrie des Kühlkörpers angepasst sein. Der Kanal kann beispielsweise derart ausgebildet sein, dass die Wandstärke des Kühlkörpers abschnittsweise konstant ist. Der Verlauf des Kanals kann unabhängig davon beispielsweise zumindest teilweise mäanderförmig sein, um eine möglichst große Fläche für einen Wärmeübertrag zwischen Kühlkörper und Kühlflüssigkeit zu erzeugen. Sowohl die Form als auch der Flächeninhalt eines Querschnitts des Kanals können vorteilhafterweise entlang des Verlaufs des Kanals variieren und müssen nicht konstant sein. Der Kanal kann abschnittsweise in seinem Querschnitt rund und/oder polygonförmig, wie rechteckig, sein, wobei die Ecken abgerundet sein können.

Der Einlass und der Auslass des Kanals können Befestigungsmittel für Fluidleitungen aufweisen, sodass eine Kühlflüssigkeit beispielsweise über eine erste Fluidleitung zum Einlass des Kanals transportiert werden kann und über eine zweite vom Auslass des Kanal wegtransportiert werden kann. In optionalen Ausgestaltungsformen des Kanals, kann der Kanal so ausgebildet sein, dass die Funktion des Kühlers von einer Flussrichtung der Kühlflüssigkeit unabhängig ist. In diesen optionalen Fällen sind Einlass und Auslass des Kanals in der obigen und nachfolgenden Beschreibung folgenlos vertauschbar.

Der Kanal weist außerdem eine Innenkühlfläche auf. Die Innenkühlfläche ist eine Teilfläche der Kanalwand und als Projektion der Außenkühlfläche auf die nächstgelegene Kanalwand ausgebildet. Die geraden Projektionslinien der Projektion können so gewählt sein, dass sie die kürzeste Verbindung zwischen einem Punkt der Außenkühlfläche und der Kanalwand bilden. Die Innenkühlfläche kann damit der Bereich der Kanalwand sein, der den geringsten thermischen Widerstand zur Außenkühlfläche aufweist. Es kann Ausführungsformen geben, in denen der zur Außenkühlfläche nächstgelegene Abschnitt der Kanalwand parallel zur Außenkühlfläche ausgebildet ist. In diesem Fall ergibt sich die Innenkühlfläche als Orthogonalprojektion der Außenkühlfläche auf die Kanalwand.

In optionalen Fällen, kann der Kühler mehrere Außenkühlflächen aufweisen, dabei können sich jeweils Innenkühlflächen als Orthogonalprojektion der jeweiligen Außenkühlfläche auf die Kanalwand ergeben. Unabhängig davon können Bereiche der Außenfläche des Kühlkörpers, die nicht zur Außenkühlfläche zu zählen sind, zum Kühlen weiterer elektronischer Schaltungen und/oder zum zusätzlichen Kühlen des zumindest einen Prozessors geeignet sein. Der Kühlkörper kann also insbesondere zum Kühlen mehrerer elektronische Komponenten, die beispielsweise auf einer Platine angeordnet sein können, ausgebildet sein.

Der Kühlkörper weist zudem zumindest einen Luftspeicher auf, der mit dem Kanal verbunden ist. Der Luftspeicher ist gewöhnlich zumindest ein Volumen, das vom Kühlkörper umschlossen ist und eine Verbindung mit dem Kanal aufweist. Weiter ist der Luftspeicher außerhalb der Projektionslinien der Innenkühlfläche und der Außenkühlfläche angeordnet. Für die folgende Beschreibung werden zwei Einbaulagen, eine erste und eine zweite Einbaulage, definiert, die jeweils eine bestimmte Orientierung des Kühlers zur Richtung der Schwerkraft beschreiben. Es können auch mehrere Einbaulagen vorgesehen sein. Bestimmte Einbaulagen können beispielsweise dadurch bedingt sein, dass ein Prozessor, insbesondere eine CPU oder eine GPU, auf einer Platine angeordnet ist. Die Platine kann unter einem Winkel von im Wesentlichen 90° steckbar in einer Hauptplatine angeordnet sein. Im Wesentlichen 90° heißt hierbei, dass Abweichungen von höchstens 10°, vorzugsweise höchstens 5°, insbesondere höchstens 2° von 90° möglich sind. Die Hauptplatine ist typischerweise im Wesentlichen horizontal oder vertikal ausgerichtet, beispielsweise in Bezug auf ein Computergehäuse, wodurch entsprechend vertikale beziehungsweise horizontale Orientierungen des Prozessors bedingt sein können. Wenn hier und nachfolgend von vertikalen oder horizontalen Richtungen die Rede ist, sind auch Richtungen mit eingeschlossen, die vorzugsweise weniger als 15°, besonders bevorzugt weniger 10°, ganz besonders bevorzugt weniger als 5°, insbesondere weniger als 2° von der vertikalen oder horizontalen Richtung abweichen.

Der Luftspeicher ist derart ausgebildet, dass in jeder der beiden Einbaulagen Luft und/oder ein Gas in zumindest ein Teilvolumen des Luftspeichers abscheidbar ist. "In ein Teilvolumen des Luftspeichers abscheidbar" bedeutet im Zusammenhang mit dem Luftspeicher, dass ein Gas, das sich von der Kühlflüssigkeit trennt oder von ihr mitgeführt wird, in den Luftspeicher leitbar ist und auch dort verbleiben bzw. gesammelt werden kann. Da der Luftspeicher nicht im Bereich der Innenkühlfläche angeordnet ist, kann erreicht werden, dass sich ein Gas, das aus der Kühlflüssigkeit in ein Teilvolumen des Luftspeichers abgeschieden wird, nicht im Bereich der Innenkühlfläche ansammeln kann und vorbeiströmende Kühlflüssigkeit dort nicht verdrängt. Die Kühlflüssigkeit kann also im Wesentlichen vollständig in Kontakt mit der Innenkühlfläche sein, wodurch Wärme effizient über die Kühlflüssigkeit abgeführt werden kann. Insbesondere kann mehr als 90 %, vorteilhafterweise mehr als 95 % oder ganz besonders vorteilhaft mehr als 99 % der Innenkühlfläche in Kontakt mit der Kühlflüssigkeit sein.

Der Luftspeicher kann optional in Bereichen des Kanals angeordnet sein, an denen bei der Durchströmung mit der Kühlflüssigkeit Grenzschichtablösungen, das heißt zu einer Loslösung der Flüssigkeit von der Kanalwand, von der Kanalwand entstehen. Solche Bereiche können auch als Toträume oder Wirbelräume bezeichnet werden. Toträume können beispielsweise entlang der Flussrichtung der Kühlflüssigkeit nach scharfen Kanten des Kanalverlaufs oder plötzlichen Vergrößerungen des Kanalquerschnitts entstehen. In Verbindung mit den Luftspeichern können die entstandenen Toträume gezielt dazu genutzt werden, Gas, das aus der Kühlflüssigkeit abgeschieden wird, aufzunehmen und zu speichern. Der Luftspeicher kann auch nach einer Richtungsänderung des Kanalverlaufs winklig zur oder entgegen der Flussrichtung der Kühlflüssigkeit angeordnet sein.

Vorteilhafterweise kann in jeder der beiden Einbaulaugen jeweils zumindest ein Teilvolumen des Luftspeichers in Richtung der Schwerkraft höher angeordnet sein, als zumindest ein zum Luftspeicher benachbarter Bereich des Kanals. Dadurch kann ein dorthin abgeschiedenes Gas in keiner der beiden Einbaulaugen aus dem jeweiligen Teilvolumen entweichen, was in jeder Einbaulage eine dauerhafte Speicherung des Gases in diesem Teilvolumen ermöglicht. In einer optionalen Ausgestaltung der Erfindung können Bereiche des Kanals, die nicht an den Luftspeicher angrenzen, in zumindest einer der beiden Einbaulagen höher angeordnet sein als das Teilvolumen des Luftspeichers, in das ein Gas abscheidbar ist. Das zuvor beschriebene Teilvolumen muss dabei nicht zwingend für jede der Einbaulaugen identisch sein. Es kann sich beispielsweise um unterschiedliche Teilvolumina handeln, wobei beispielsweise in einer ersten Einbaulage Luft in ein erstes Teilvolumen abscheidbar ist und in einer zweiten Einbaulage Luft in ein zweites Teilvolumen abscheidbar ist. Das erste und zweite Teilvolumen können sich dabei zumindest teilweise überlappen oder disjunkt, also separat, sein.

Optional kann der Querschnitt des Kanals im Bereich der Innenkühlfläche kleiner sein als in einem unmittelbar in Flussrichtung der Kühlflüssigkeit vorgelagerten Bereich des Kanals. Die Querschnittsverkleinerung des Kanals im Bereich der Innenkühlfläche kann dazu führen, dass sich die Fließgeschwindigkeit der Kühlflüssigkeit in diesem Bereich erhöht. Wärme kann dann effizient abgeführt werden, weil die Wahrscheinlichkeit verringert wird, dass es im Bereich der Innenkühlfläche zu einer Grenzschichtablösung der Kühlflüssigkeit kommt, wodurch erreicht wird, dass die Kühlflüssigkeit in Kontakt mit der Innenkühlfläche ist. Abscheidung des in der Kühlflüssigkeit gelösten Gases oder des von der Kühlflüssigkeit mitgeführten Gases findet typischerweise bei geringen Fließgeschwindigkeit statt.

In einer optionalen Ausführungsform des Kühlers, ist die Außenkühlfläche derart ausgebildet, dass sie sich in der ersten Einbaulage des Kühlers im Wesentlichen senkrecht zur Richtung der Schwerkraft erstreckt und/oder in der zweiten Einbaulage im Wesentlichen parallel zur Richtung der Schwerkraft ausgerichtet erstreckt. Das kann bedeuten, dass die Außenkühlfläche in der ersten Einbaulauge im Wesentlichen horizontal und in der zweiten Einbaulage im Wesentlichen vertikal ausgerichtet ist. Die Außenkühlfläche kann an die Form des zu kühlenden Prozessors angepasst sein und muss beispielsweise nicht zwingend eben sein.

In einer weiteren Ausgestaltung der Erfindung, kann der Luftspeicher zwei Luftspeichersegmente aufweisen, beispielsweise eine erstes Luftspeichersegment und ein zweites Luftspeichersegment, die räumlich voneinander beabstandet sind und lediglich über den Kanal fluidisch miteinander verbunden sind. Die beiden Luftspeichersegmente können beispielsweise so ausgebildet sein, dass in der ersten Einbaulage Gas in ein Teilvolumen des ersten Luftspeichersegments abscheidbar ist und in der zweiten Einbaulage ein Gas in ein Teilvolumen des zweiten Luftspeichersegments abscheidbar ist. Es ist ebenso vorstellbar, dass in jeder der beiden Einbaulagen ein Gas in jedes der beiden Luftspeichersegmente abgeschieden wird.

Es ist ebenso eine Ausführungsform des Kühlers für einen Prozessor vorstellbar, in der die Außenkühlfläche eine Befestigungsmöglichkeit für einen Prozessor aufweist. Die Befestigungsmöglichkeit kann beispielsweise über Befestigungsmittel wie Schrauben oder Klammern verfügen. Vorteilhafterweise kann durch die Befestigungsmittel ein Anpressdruck aufgebaut werden, der eine schlüssige Verbindung zwischen der Außenkühlfläche und einer Fläche des Prozessors, die zum Ableiten der Abwärme ausgebildet ist, ermöglicht. Es sind aber ebenso Befestigungsmittel wie Klebe- oder Wärmeleitpads denkbar. Um den Wärmeübertrag vom Prozessor auf die Außenkühlfläche zu erhöhen, können unabhängig von einer Befestigungsmöglichkeit auch oder zusätzlich Mittel benutzt werden wie beispielsweise Wärmeleitpaste oder Wärmeleitpads.

In einer weiteren optionalen Ausführungsform der Erfindung weist der Kühler zwei miteinander verbundene Schalen auf. Eine erste Schale weist dabei eine erste Verbindungsfläche und eine zweite Schale eine zweite Verbindungsfläche auf. Die beiden Schalen kommen an den Verbindungsflächen zur Anlage, sind an den jeweiligen Verbindungsflächen miteinander verbunden und formen im Verbund den Kühlkörper, den Kanal und den oder die Luftspeicher. Die beiden Schalen können dabei derart ausgeformt sein, dass die Kanalwand an jeder Stelle eines bestimmten Abschnitts des Kanalverlaufs sowohl Teil der ersten Schale als auch Teil der zweiten Schale ist. Optional kann der Kanal zumindest abschnittsweise senkrecht zu den Verbindungsflächen der Schalen verlaufen. Unabhängig davon kann der Kanal zumindest teilweise parallel zu den Verbindungflächen verlaufen und/oder zumindest teilweise entlang der Verbindungsflächen verlaufen.

Jede der beiden Schalen kann auch selbst jeweils aus mehreren Schalenbauteilen zusammengesetzt sein. Es ist ebenso denkbar, dass der Kühlkörper selbst aus mehreren Bauteilen zusammengesetzt wird, die nachfolgend ebenfalls als Schalenbauteile bezeichnet werden sollen. An Verbindungsflächen, insbesondere den Verbindungsflächen der Schalen, können zudem Dichtelemente vorgesehen sein, die eine dichte Verbindung der beiden Schalen gewährleisten. Die Schalen und/oder die Schalenbauteile können über verschieden Verbindungsmittel miteinander verbunden werden. Beispielhaft seien hier Schrauben, Bolzen oder Klammern genannt. Ebenso denkbar sind Verbindungen mittels Fügen, Kleben und/oder Schweißen. Die beiden Schalen und/oder die Schalenbauteile können beispielsweise in einem Fräs-, Spitzguss-, einem Druckguss- oder einem 3D-Druckverfahren hergestellt werden. Zumindest eine der Schalen kann beispielsweise aus Aluminium gefertigt sein.

In einer weiteren Ausgestaltung der Erfindung weist die Innenkühlfläche einen Mikrokanalwärmetauscher auf, der entlang der Flussrichtung ausgerichtete Rillen aufweist. Das ermöglicht eine Vergrößerung der umströmten Oberfläche was zu einem verbesserten Wärmeaustausch an der Innenkühlfläche beiträgt. Es sind auch Ausgestaltungsformen der Innenkühlfläche denkbar, die den Wärmeübertrag an der Innenkühlfläche erhöhen, beispielsweise durch Oberflächenfunktionalisierung. Unabhängig davon ist vorstellbar die Innenkühlfläche in Flussrichtung der Kühlflüssigkeit konvex auszubilden oder den Querschnitt des an die Innenkühlfläche angrenzenden Kanals sich in Flussrichtung kontinuierlich verjüngend auszubilden.

In einer optionalen Ausgestaltung der Erfindung kann der Luftspeicher derart ausgebildet sein, dass in jeder der beiden Einbaulagen zumindest ein entsprechendes Teilvolumen innerhalb des Luftspeichers entlang der Schwerkraft höher angeordnet ist, als jeder Punkt der Innenkühlfläche. Es kann beispielsweise vorgesehen sein, dass in einer ersten Einbaulage ein erstes Teilvolumen, in einer zweiten Einbaulage ein zweites Teilvolumen und in einer dritten Einbaulage ein drittes Teilvolumen innerhalb des Luftspeichers entlang der Schwerkraft höher angeordnet sein, als jeder Punkt der Innenkühlfläche. Die Anzahl der Einbaulagen ist dabei nicht auf drei beschränkt. Die beschriebenen Teilvolumen können unterschiedliche Teilvolumen sein, die beispielsweise disjunkt sein können. Durch diese Anordnung kann bei bestimmten Kanalverläufen erreicht werden, dass sich ein abgeschiedenes Gas und/oder abgeschiedene Luft in dem betreffenden Teilvolumen sammelt und dort verbleibt.

In einer weiteren optionalen Ausgestaltung der Erfindung kann in zumindest einer Einbaulage ein Teilvolumen des Luftspeichers niedriger angeordnet sein als der höchste Punkt der Innenkühlfläche. Dies wird durch eine spezielle Ausbildung des Kanals und der Luftspeicher ermöglicht und erlaubt eine kompaktere und/oder flexiblere Ausgestaltung des Kühlers. Luftspeicher und Innenkühlfläche sind zueinander beabstandet angeordnet.

In einer besonders bevorzugten Ausgestaltungsform der Erfindung können sich in den Luftspeichern elastische Kompensationselemente befinden, die es ermöglichen, das vom Kühler umschlossene Gesamtvolumen zu variieren. Beim Verbinden des Kühlers mit anderen Komponenten eines Kühlkreislaufs kann es zu unerwünschten Druckanstiegen innerhalb des Kühlkreislaufs kommen. Beispielsweise kann es beim Zusammenführen von mit Flüssigkeit gefüllten Fluidleitungen, bei gleichbleibender Flüssigkeits-/Gasmenge zu einer Reduktion des flüssigkeitsführenden Volumens kommen. Dadurch kann der Druck innerhalb des Volumens steigen. Die elastischen Elemente können dem Druck nachgeben und den Druckanstieg durch eine Vergrößerung des umschlossenen Volumens kompensieren. Die elastischen Kompensationselemente können aus Schaumstoff gefertigt oder als gasgefüllte Kissen ausgebildet sein, grundlegend sind jedoch alle Materialien denkbar die, wenn ein Druck auf sie ausgeübt wird, der Druckrichtung folgend nachgeben können.

Außerdem wird ein System zur Kühlung eines Prozessors vorgeschlagen. Das System weist neben dem oben beschriebenen Kühler für einen Prozessor auch eine Pumpe und einen Radiator auf. Kühler, Pumpe und Radiator sind dabei über Fluidleitungen fluidisch mit einander verbunden, sodass Kühlflüssigkeit mit der Pumpe durch die Fluidleitungen, den Kanal des Kühlers, und den Radiator gepumpt werden kann. Im Kühler wird an der Innenkühlfläche Wärme an die Kühlflüssigkeit abgegeben. Die dadurch erwärmte Kühlflüssigkeit wird darauffolgend durch den Radiator geleitet und gibt ihre Wärme an diesen ab. Der Radiator ist dabei in der Regel beabstandet zum Kühler angeordnet. Die wieder erkaltete Kühlflüssigkeit wird daraufhin wieder in den Kühler zur Innenkühlfläche geleitet, die ihre Wärme wieder an die Kühlflüssigkeit abgibt. Der beschriebene Kühlkreislauf erlaubt die Kühlung zumindest eines Prozessors, der seine Wärme an die Außenkühlfläche des Kühlers abgibt. Das System kann weiter einen Lüfter aufweisen, der dazu ausgebildet ist, den Radiator zu kühlen, und vorzugsweise am Radiator angeordnet ist.

Gemäß einem weiteren Aspekt wird ein Verfahren zum Kühlen eines Prozessors bereitgestellt, das die folgenden Schritte aufweist. Der Kühler wird in eine seiner beiden Einbaulagen ausgerichtet. Eine Einbaulage kann beispielsweise eine Ausrichtung des Kühlers sein, in der der Kühler an einem Prozessor befestigt werden kann. Der Prozessor kann seinerseits beispielsweise auf einer Platine in einem PC Gehäuse befestigt sein. Der Kühler kann beispielsweise auch derart ausgerichtet werden, dass eine Längsachse des Kühlers horizontal oder vertikal verläuft. Der Kühler kann beispielsweise so ausgebildet sein, dass sich die die Außenkühlfläche in einer ersten Einbaulage im Wesentlichen horizontal erstreckt und/oder in einer zweiten Einbaulage im Wesentlichen vertikal erstreckt. Es sind aber ebenso Ausführungsformen des Verfahrens denkbar, in denen die Außenkühlfläche in keiner Einbaulage horizontal und/oder vertikal ausgerichtet ist. In einem weiteren Verfahrensschritt wird eine Kühlflüssigkeit durch den Kanal des Kühlers geleitet. Die Kühlflüssigkeit kann in optionalen Ausführungsformen über Fluidleitungen zum Kühler hin und/oder vom Kühler weggeführt werden. Luft und/oder in der Kühlflüssigkeit gelöstes Gas und/oder von der Kühlflüssigkeit mitgeführtes Gas kann beim Durchleiten der Flüssigkeit in die dafür vorgesehen Teilvolumen der Luftspeicher des Kühlers abgeschieden werden, sodass die Innenkühlfläche des Kühlers in Kontakt mit dem Kühlflüssigkeit ist. Dabei kann Wärme an die Kühlflüssigkeit abgegeben werden. Es ist weiter denkbar einen Kühlkreislauf herzustellen und die Kühlflüssigkeit, die die Wärme aufgenommen hat, durch einen Radiator zu leiten, der die Wärme der Kühlflüssigkeit aufnimmt. Die durch den Radiator abgekühlte Kühlflüssigkeit kann dann wieder durch den Kühler geleitet werden.

Es versteht sich, dass die oben beschriebenen Merkmale des Kühlers, des Kühlsystems und des Verfahrens miteinander kombinierbar sind, soweit sie sich nicht widersprechen.

Verschiedene Ausführungsformen der Erfindung sind in zwei Figuren schematisch dargestellt und werden nachfolgend beispielhaft erläutert.

Es zeigt:
Fig. 1 Schnittansichten einer ersten Ausführungsform eines Kühlers für einen Prozessor in zwei Einbaulagen;
Fig. 2 Schnittansichten einer zweiten Ausführungsform eines Kühlers für einen Prozessor in zwei Einbaulagen;
Fig. 3 eine schematische Darstellung eines Systems zur Kühlung eines Prozessors; und
Fig. 4 eine schematische Darstellung eines Verfahrensablaufs zum Betreiben eines Kühlers.

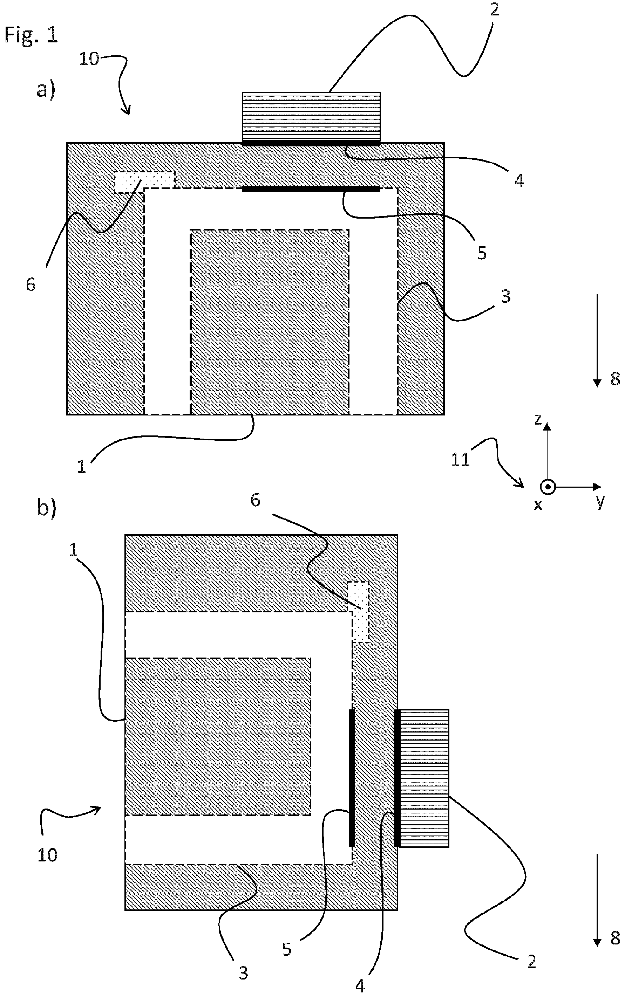

Figur 1 zeigt Schnittansichten einer ersten Ausführungsform eines Kühlers 10 für einen Prozessor 2 in zwei Einbaulagen. Eine Richtung der Schwerkraft 8 zeigt in der Figur 1 nach unten und kann als negative z-Richtung eines kartesischen Koordinatensystems 11 angesehen werden. Figur 1a zeigt eine erste Einbaulage des Kühlers 10 in der der Prozessor 2 im Wesentlichen horizontal ausgerichtet ist, Figur 1b zeigt den Kühler 10 für einen Prozessor 2 in einer zweiten Einbaulage, in der der Prozessor 2 im Wesentlichen vertikal ausgerichtet ist. Die Figur 1b zeigt also den Kühler 10 für einen Prozessor 2 der Figur 1a der um 90° im Uhrzeigersinn um die x-Achse des gezeigten Koordinatensystems 11 gedreht wurde. Die beiden gezeigten Einbaulagen sind dabei als Beispiele für zwei Einbaulagen zu verstehen. Es sind ebenso Einbaulagen vorstellbar, die nicht in einem Winkel von 90° zueinander angeordnet sind. Weiter sind Einbaulagen denkbar die weder senkrecht, noch parallel zur Richtung der Schwerkraft ausgerichtet sind.

Im Folgenden wird der Kühler 10 in seiner ersten Einbaulage, wie in Figur 1a gezeigt, beschrieben. Die Figuren 1a und 1b zeigen eine Schnittansicht eines Kühlkörpers 1, der im Profil im Wesentlichen rechteckig ausgeformt ist. Das Profil des Kühlkörpers ist allerdings nicht auf rechteckige Formen beschränkt.

Die Außenkühlfläche 4 ist in der ersten Einbaulage (Fig. 1a) an einer Oberseite des Kühlkörpers 1 angeordnet. Die Außenkühlfläche 4 kann in optionalen Ausgestaltungsformen Befestigungselemente für elektronische Bauteile, beispielsweise für Prozessoren 2, aufweisen. Die Außenkühlfläche 4 selbst kann optional an die Fläche eines elektronischen Bauteils angepasst sein. Ebenso kann die Außenkühlfläche 4 aus zwei voneinander getrennten Flächen ausgebildet sein. Es sind ebenso Ausgestaltungsformen denkbar, in denen mehrere Außenkühlflächen 4 mit entsprechenden Innenkühlflächen 5 ausgebildet sind.

Unabhängig davon kann es möglich sein mehrere Elemente, beispielsweise mehrere Prozessoren 2 und/oder zusätzlich zu einem Prozessor weitere elektronischen Komponenten, zu kühlen. Es kann insbesondere möglich sein, dass der Kühlkörper 1 mit mehreren Elemente oder Bereichen einer Platine, die Wärme produzieren, in Kontakt ist. Der Kühler 1 kann zudem derart ausgebildet sein, dass er von zumindest zwei elektronischen Komponenten, die auf einer Platine angeordnet sind, Wärme aufnehmen kann, wobei zumindest eines dieser Elemente mit der zumindest einen Außenkühlfläche 4 in Kontakt stehen kann. In manchen Ausführungsformen kann der Kühler 10 dazu ausgebildet sein die Wärme von zumindest zwei elektronischen Komponenten, die beispielsweise auf einer Grafikkarte angeordnet sind, aufzunehmen. Die Au-βenkühlfläche 4 ist an einem Prozessor 2 angeordnet. Ein Kanal 3 verläuft durch den Kühlkörper 1. In der gezeigten ersten Einbaulage sind beispielsweise sowohl ein Einlass und ein Auslass des Kanals 3 an einer Unterseite des Kühlkörpers 1 angeordnet. Der Kanal 3 verläuft in diesem Beispiel vom Einlass aus vertikal nach oben, also entgegengesetzt zur Richtung der Schwerkraft 8, geht dann in einen horizontalen Abschnitt über, und verläuft schließlich vertikal nach unten in Richtung des Auslasses. Die Flussrichtung der Kühlflüssigkeit ist in diesem Ausführungsbeispiel unerheblich. Es existiert in diesem Beispiel also keine bevorzugte Flussrichtung des Kühlfluids. Es sind allerdings durchaus Ausführungsformen denkbar, in denen die Flussrichtung von Bedeutung sein kann.

Eine Innenkühlfläche 5 ist an der Oberseite im horizontalen Abschnitt des Kanals 3 als Orthogonalprojektion der Außenkühlfläche 4 ausgebildet. Die Innenkühlfläche 5 ist in der gezeigten Ausführungsform als ebene Fläche dargestellt. Es sind auch Ausführungsformen denkbar, in denen die Innenkühlfläche 5 in Flussrichtung der Kühlflüssigkeit konvex ausgebildet ist. Das bedeutet, dass eine parallel zur Flussrichtung verlaufende Verbindungslinie zwischen zwei Punkten der Innenkühlfläche 5 vollständig innerhalb des Materials des Kühlkörpers verläuft. Unabhängig davon ist vorstellbar, dass sich der Querschnitt des Kanals 3 im Bereich der Innenkühlfläche entlang der Flussrichtung des Kühlfluids stetig verjüngt. Dadurch kann beispielsweise die Wahrscheinlichkeit für Grenzschichtablösungen im Bereich der Innenkühlfläche verringert werden, da sich die Fließgeschwindigkeit des Kühlfluids in diesem Bereich stetig erhöht. Weiter sind Ausführungsformen denkbar, in denen die Innenkühlfläche 5 Rippen aufweist, die parallel zur Flussrichtung angeordnet sind. Dadurch kann beispielsweise die Oberfläche der Innenkühlfläche erhöht werden, was den Wärmeaustausch begünstigt.

Der Kühlkörper weist zudem mindestens einen Luftspeicher 6 auf, der außerhalb von geraden Verbindungslinien bzw. Projektionslinien zwischen Innenkühlfläche 5 und Außenkühlfläche 4 angeordnet ist und fluidisch mit dem Kanal 3 verbunden ist. In diesem Ausführungsbeispiel ist der Luftspeicher 6 derart angeordnet und ausgebildet, dass in jeder der beiden Einbaulagen, also sowohl in Figur 1a als auch Figur 1b, ein Teilvolumen oder das Gesamte Volumen des Luftspeichers 6 in Richtung der Schwerkraft höher angeordnet ist, als jeder Punkt der Innenkühlfläche 5. Wird ein Gas und/oder Luft aus der Kühlflüssigkeit abgeschieden, kann es im Luftspeicher 6 gesammelt werden, sodass die Innenkühlfläche im Wesentlichen vollständig, bevorzugt zu mehr als 90 %, zu mehr als 95 % oder zu mehr als 99 % in Kontakt mit der Kühlflüssigkeit ist. Es sind auch Ausführungsformen denkbar, in denen der Luftspeicher 6 ein erstes Luftspeichersegment und ein zweites Luftspeichersegment aufweist, die nur über den Kanal fluidisch miteinander verbunden sind. Dabei kann das erste Luftspeichersegment ein erstes Teilvolumen aufweisen, in das in der ersten Einbaulage Luft und/oder Gas abscheidbar ist, und das zweite Luftspeichersegment ein zweites Teilvolumen aufweisen, in das in der zweiten Einbaulage Luft und/oder Gas abscheidbar ist.

Außerdem sind auch mehr als zwei Einbaulagen denkbar, in denen Luft in einen Luftspeicher abgeschieden werden kann, beispielsweise drei, vier oder mehr als vier Einbaulagen.

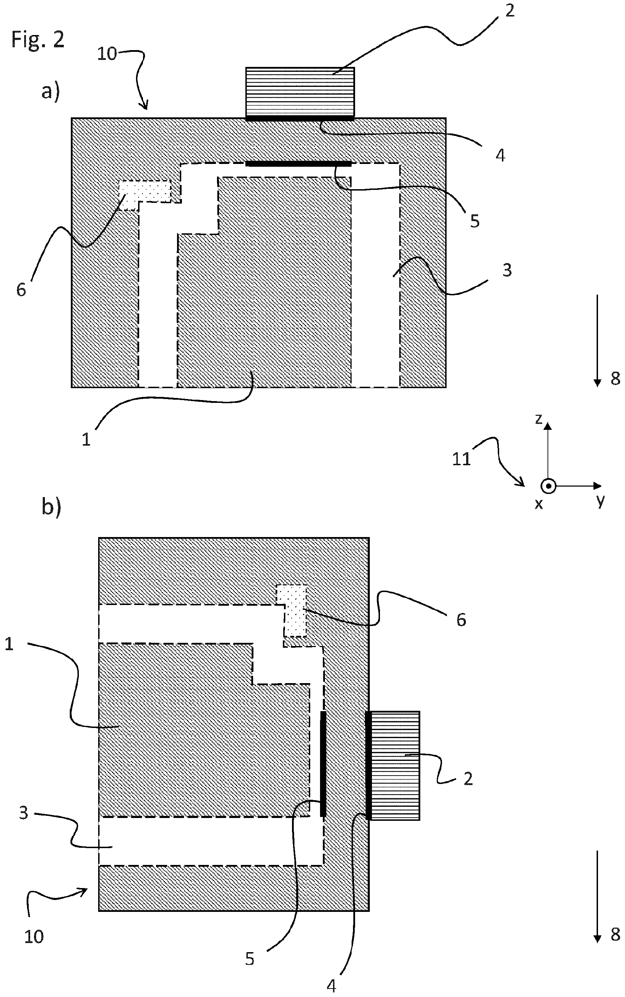

Die Figuren 2a und 2b zeigen ebenfalls Schnittansichten einer Ausgestaltungsform eines Kühlers 10 für einen Prozessor in zwei verschiedenen Einbaulagen. In einer ersten Einbaulage, wie in Figur 2a dargestellt, erstreckt sich eine Au-βenkühlfläche 4 im Wesentlichen horizontal, das bedeutet die Außenkühlfläche 4 erstreckt sich im Wesentlichen orthogonal zur Richtung der Schwerkraft 8. Die Schwerkraft 8 ist in den Figuren 2a und 2b nach unten gerichtet. Figur 2b zeigt eine Schnittansicht des Kühlers 10 für einen Prozessor 2 in einer zweiten Einbaulage, in der sich die Außenkühlfläche 4 im Wesentlichen in vertikaler Richtung, also parallel zur Richtung der Schwerkraft 8, erstreckt. Im Folgenden wird der Kühler 10 der Figur 2a beschrieben. Der Kühler 10 der Figur 2b ergibt sich durch Drehung des Kühlers 10 der Figur 2a um 90° im Uhrzeigersinn um die x-Achse des Koordinatensystems 11, also die Achse, die orthogonal auf der Ansichtsebene steht.

Der Kühlkörper 1 ist in der dargestellten Ausgestaltungsform der Erfindung im Profil rechteckig ausgebildet. Ein Kanal 3 verläuft in dem Beispiel der Figur 2a von einem Einlass ausgehend senkrecht nach oben und geht anschließend in einen ersten horizontal verlaufenden Abschnitt über. Auf den ersten horizontal verlaufenden Abschnitt folgt ein weiterer vertikal nach oben verlaufender Abschnitt der in einen zweiten horizontalen Abschnitt übergeht. Der zweite horizontal verlaufende Abschnitt geht schließlich in einen vertikal nach unten verlaufenden Abschnitt über, der zu einem Auslass des Kanals führt. Auch in dieser Ausgestaltungsform ist die Flussrichtung der Kühlflüssigkeit unerheblich. Es existiert in diesem Beispiel also keine bevorzugte Flussrichtung des Kühlfluids. Es sind allerdings durchaus Ausführungsformen denkbar, in denen die Flussrichtung von Bedeutung sein kann.

Eine Innenkühlfläche 5 ist im zweiten horizontal verlaufenden Kanalabschnitt als Orthogonalprojektion der Außenkühlfläche 4 ausgebildet. Der Querschnitt des Kanals kann, wie beispielhaft in Figur 2 gezeigt, im Bereich der Innenkühlfläche 5 kleiner sein als in den beiden umliegenden Kanalabschnitten.

Der Kühlkörper weist einen Luftspeicher 6 auf, der eine Verbindung zum ersten horizontal verlaufenden Kanalabschnitt aufweist. Der Luftspeicher 6 kann beispielsweise mit dem Kanal 3 an einer Stelle des Kanalverlaufs verbunden sein, an der es zu einer Grenzschichtablösung der Kühlflüssigkeit von der Kanalwand kommen kann. Der durch die Grenzschichtablösung entstandene Totraum wird durch den Luftspeicher 6 vergrößert und dient der Aufnahme und Speicherung des abgeschiedenen Gases und/oder der abgeschiedenen Luft.

Der Luftspeicher 6 kann derart ausgebildet sein, dass er in der ersten beispielhaften Einbaulage, die in Figur 2a dargestellt ist, niedriger angeordnet ist als jeder Punkt der Innenkühlfläche 5. In der zweiten Einbaulage, dargestellt in Figur 2b, ist der gesamte Luftspeicher 6 beispielsweise in Richtung der Schwerkraft 8 höher angeordnet als jeder Punkt der Innenkühlfläche 5. Es sind ebenso Ausführungsformen möglich, in denen zumindest ein für jede Einbaulage anders bemessenes Teilvolumen des Luftspeichers 6 höher angeordnet ist, als die Innenkühlfläche 5.

Der Luftspeicher 6 kann, sowohl in der Fig. 1 als auch in der Fig. 2, als konkave Ausbuchtung in der Kanalwand ausgestaltet sein.

Der gezeigte Kühlkörper 1 kann beispielsweise aus Aluminium hergestellt sein oder zumindest teilweise oder überwiegend daraus hergestellt sein. Unabhängig davon kann der Kühlkörper 1 oder Teile des Kühlkörpers 1 beispielsweise in einem Spritzguss-, Druckguss- oder 3D Druckverfahren hergestellt werden. In einer Ausgestaltungsform des Kühlkörpers 1 kann dieser Haltemittel aufweisen, mit denen der Kühlkörper 1 beispielsweise in einem Gehäuse, insbesondere in einem Computergehäuse, gehaltert werden kann. In einer optionalen Ausgestaltung des Kühlkörpers 1 kann der Kühlkörper 1 Befestigungsmittel für Sensoren aufweisen deren Signale zur Steuerung und/oder für Steuerungsmittel eines Kühlkreislaufs verwendet werden können.

Optional kann der Kühlkörper 1 zwei oder mehreren Schalen aufweisen oder daraus bestehen. Die zumindest zwei Schalen kommen an den Verbindungsflächen zur Anlage, sind an den jeweiligen Verbindungsflächen miteinander verbunden und formen im Verbund den Kühlkörper 1, den Kanal 3 und den oder die Luftspeicher 6. Die beiden Schalen können dabei derart ausgeformt sein, dass die Kanalwand an jeder Stelle eines bestimmten Abschnitts des Kanalverlaufs sowohl Teil der ersten Schale als auch Teil der zweiten Schale ist. Optional kann der Kanal 3 zumindest abschnittsweise senkrecht zu den Verbindungsflächen der Schalen verlaufen. Unabhängig davon kann der Kanal 3 zumindest teilweise parallel zu den Verbindungflächen verlaufen und/oder zumindest teilweise entlang der Verbindungsflächen verlaufen.

In einer weiteren optionalen Ausgestaltung kann der Kühler 10 nicht gezeigte Kompensationselemente aufweisen, mit denen das vom Kühlkörper 1 umschlossen Gesamtvolumen veränderbar ist. Die elastischen Elemente können bei Druckanstieg nachgeben und beispielsweise ihre Form oder ihr Volumen verändern. Dadurch kann ein Druckanstieg durch eine Vergrößerung des umschlossenen Volumens kompensiert werden. Die elastischen Kompensationselemente können aus Schaumstoff gefertigt oder als gasgefüllte Kissen ausgebildet sein, grundlegend sind jedoch alle Materialien denkbar die, wenn ein Druck auf sie ausgeübt wird, der Druckrichtung folgend nachgeben können. Die Kompensationselemente können unabhängig davon an Stellen des Kanals 3 und/oder des Luftspeichers 6 angeordnet sein.

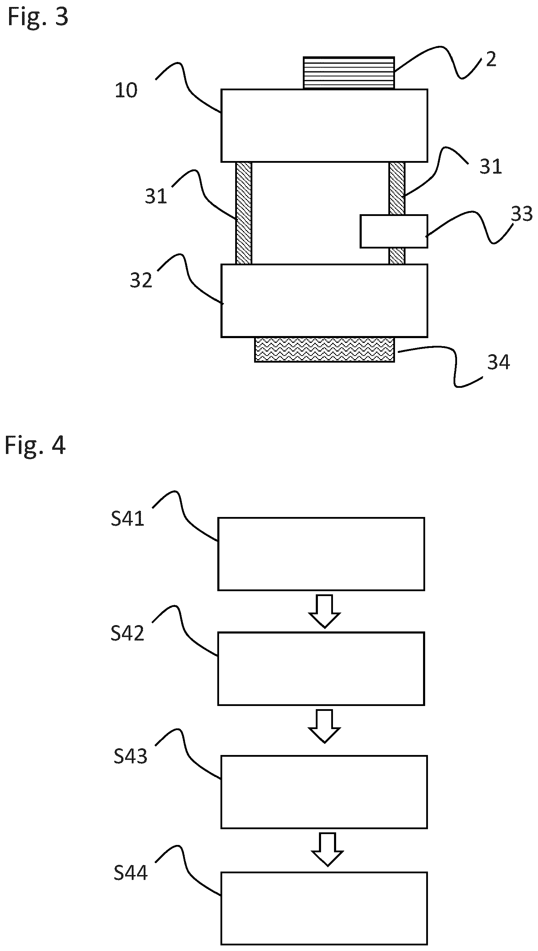

Figur 3 zeigt eine schematische Darstellung eines Systems zur Kühlung eines Prozessors 2. Das System weist einen Kühler 10 auf, der über Fluidleitungen 31 fluidisch mit einem Radiator 32 verbunden ist. Der Kühler kann beispielsweise einer der Kühler 10 aus den Figuren 1 oder 2 sein. Der Kühler 10 ist mit seiner Außenkühlfläche 4 an einem Prozessor 2 angeordnet. Kühlflüssigkeit kann mittels einer Pumpe 33 durch die Fluidleitungen 31, durch den Radiator 32 und durch den Kanal 3 des Kühlers 10 gepumpt werden. Wärme, die beispielsweise vom Prozessor 2 erzeugt wird, kann vom Kühler 10 aufgenommen werden und an die Kühlflüssigkeit abgegeben werden. Die Kühlflüssigkeit wird anschließend mit der Pumpe 33 durch die Fluidleitung 31 zu einem Radiator 32 gepumpt. Der Radiator 32 ermöglicht die Abkühlung der Kühlflüssigkeit, beispielsweise dadurch, dass die Wärme der Kühlflüssigkeit über den Radiator 32 an die den Radiator 32 umgebende Luft abgegeben wird. Ein System zur Kühlung eines Prozessors kann außerdem einen Lüfter 34 aufweisen. In Figur 3 ist der Lüfter 34 am Radiator 32 angeordnet und/oder befestigt. Der Lüfter 34 kann bevorzugt zumindest derart angeordnet sein, dass die Luft, an die der Radiator 32 Wärme abgibt, durch den Lüfter bewegt 34 werden kann. Durch den Luftstrom des Lüfters 34 wird der Radiator 32 also gekühlt. Es sind anstelle des Radiators 32 jegliche Mittel denkbar, die eine Abkühlung der Kühlflüssigkeit bewirken können. Optional oder ergänzend ist auch eine Luftkühlung mittels Ventilatoren und/oder Lüfter vorstellbar.

Figur 4 zeigt eine schematische Darstellung eines Verfahrens zum Betreiben eines Kühlers 10, wobei das Verfahren die Schritte S41-S44 aufweist. Das Verfahren kann mit dem Ausrichten des Kühlers, Schritt S41, begonnen werden. Der Kühler 10 wird dabei in einer seiner Einbaulagen ausgerichtet. Der Kühler 10 kann beispielsweise ein Kühler 10 der Figuren 1 oder 2 sein. Als nächstes kann eine Kühlflüssigkeit durch den Kanal 3 des Kühlers 10 gleitet werden, vgl. Schritt S42. Dies kann beispielsweise durch die genannte Pumpe 33 erfolgen, die an einer geeigneten Stelle angeordnet ist. In einem weiteren Schritt S43 wird Luft und/oder in der Kühlflüssigkeit gelöstes Gas in ein Teilvolumen des Luftspeichers 6 abgeschieden. Außerdem wird Wärme von der Innenkühlfläche 5 des Kühlers 10 an das Kühlfluid übertragen, s. Schritt S44. Die erfolgreiche Durchführung des Verfahrens verlangt nicht, dass alle Schritte streng aufeinanderfolgen. Insbesondere das Durchleitens des Kühlfluids in Schritt S42, die Abscheidung von Luft und/oder in der Kühlflüssigkeit/dem Kühlfluid gelöstes Gas in Schritt S43 und die Abgabe von Wärme an die Kühlflüssigkeit/an das Kühlfluid in Schritt S44 verlaufen teilweise gleichzeitig und/oder gehen ineinander über. Auch ist es möglich den Kühler 10 nach den Schritten S42, S43, und S44 in einer neuen Einbaulagen auszurichten. Weitere Schritte können zum Beispiel das Anschalten der Pumpe 33 und/oder das Kühlen des Radiators 32 durch den Lüfter 34 umfassen. Das in Figur 4 gezeigte Verfahren ist somit nicht auf die Schritte S41-S44 beschränkt und kann weitere Schritte aufweisen.

### Bezugszeichenverzeichnis:

- 1: Kühlkörper
- 2: Prozessor
- 3: Kanal
- 4: Außenkühlfläche
- 5: Innenkühlfläche
- 6: Luftspeicher
- 8: Richtung der Schwerkraft
- 10: Kühler
- 11: Koordinatensystem
- 31: Fluidleitung
- 32: Radiator
- 33: Pumpe
- 34: Lüfter
- S41: Ausrichten des Kühlers
- S42: Durchleiten von Kühlflüssigkeit/Kühlfluid
- S43: Abscheiden von Luft und/oder in der Kühlflüssigkeit/dem Kühlfluid gelöstes Gas
- S44: Abgabe von Wärme an die Kühlflüssigkeit/an das Kühlfluid

## Patentansprüche

1. Kühler (10) für einen Prozessor (2), insbesondere für eine CPU oder eine GPU, aufweisend
einen Kühlkörper (1) mit zumindest einer Außenkühlfläche (4) zum Kühlen des Prozessors, die eine Teilfläche einer der Außenflächen des Kühlkörpers ist,
einen Kanal (3) zum Durchleiten einer Kühlflüssigkeit, der durch den Kühlkörper (1) verläuft, sowie
eine erste und eine zweite Einbaulage, wobei der Kühler (10) in den beiden Einbaulagen jeweils eine bestimmte Orientierung zur Schwerkraft (8) aufweist,
wobei der Kanal (3) zumindest eine Innenkühlfläche (5) aufweist, die als Projektion der Außenkühlfläche (4) auf die nächstgelegene Grenzfläche zwischen Kanal (3) und Kühlkörper (1) ausgebildet ist,
**dadurch gekennzeichnet, dass** der Kühlkörper (1) zumindest einen Luftspeicher (6) aufweist, der mit dem Kanal (3) verbunden ist,
wobei der Luftspeicher (6) außerhalb der Projektionslinien der Innenkühlfläche (5) und der Außenkühlfläche (4) angeordnet ist und derart ausgebildet ist, dass in jeder der beiden Einbaulagen Luft und/oder Gas in zumindest ein Teilvolumen des Luftspeichers (6) abscheidbar ist und die Innenkühlfläche (5) in Kontakt mit der Kühlflüssigkeit ist.

2. Kühler (10) für einen Prozessor (2) nach dem vorhergehenden Anspruch, wobei in jeder der beiden Einbaulagen zumindest ein Teilvolumen innerhalb des Luftspeichers (6) in Richtung der Schwerkraft (8) höher angeordnet ist als zumindest ein zum Luftspeicher (6) benachbarter Bereich des Kanals (3).

3. Kühler (10) für einen Prozessor (2) nach einem der vorhergehenden Ansprüche, wobei ein Querschnitt des Kanals (3) im Bereich der Innenkühlfläche (5) kleiner ist als ein Querschnitt des Kanals (3) in einem unmittelbar in Flussrichtung der Kühlflüssigkeit vorgelagerten Bereich des Kanals (3).

4. Kühler (10) für einen Prozessor (2) nach einem der vorhergehenden Ansprüche, wobei der Kühler (10) in der ersten Einbaulage so ausgerichtet ist, dass die zumindest eine Außenkühlfläche (4) senkrecht zur Schwerkraft (8) ist und in der zweiten Einbaulage so ausgerichtet ist, dass die zumindest eine Außenkühlfläche (4) parallel zur Schwerkraft (8) ist.

5. Kühler (10) für einen Prozessor (2) nach einem der vorhergehenden Ansprüche, wobei der Luftspeicher (6) ein erstes Luftspeichersegment und ein zweites Luftspeichersegment aufweist, die nur über den Kanal (3) miteinander verbunden sind,
wobei das erste Luftspeichersegment ein erstes Teilvolumen aufweist, in das in der ersten Einbaulage Luft und/oder Gas abscheidbar ist, und
das zweite Luftspeichersegment ein zweites Teilvolumen aufweist, in das in der zweiten Einbaulage Luft und/oder Gas abscheidbar ist.

6. Kühler (10) für einen Prozessor (2) nach einem der vorhergehenden Ansprüche, wobei die Außenkühlfläche (4) eine Befestigungsmöglichkeit für den Prozessor (2) aufweist.

7. Kühler (10) für einen Prozessor (2) nach einem der vorhergehenden Ansprüche, wobei der Kühler (10) zwei mit einander verbundene Schalen aufweist.

8. Kühler (10) für einen Prozessor (2) nach einem der vorhergehenden Ansprüche, wobei die Innenkühlfläche (5) eben oder konvex ausgeformt ist.

9. Kühler (10) für einen Prozessor (2) nach einem der vorhergehenden Ansprüche, wobei der zumindest eine Luftspeicher (6) derart ausgebildet ist, dass in jeder der beiden Einbaulagen zumindest ein Teilvolumen innerhalb des Luftspeichers (6) in Richtung der Schwerkraft (8) höher angeordnet ist als jeder Punkt der Innenkühlfläche (5).

10. Kühler (10) für einen Prozessor (2) nach einem der vorhergehenden Ansprüche 1 bis 8, wobei der zumindest eine Luftspeicher (6) derart ausgebildet ist, dass in zumindest einer Einbaulage der Luftspeicher (6) in Richtung der Schwerkraft (8) niedriger angeordnet ist als jeder Punkt der Innenkühlfläche (5).

11. Kühler (10) für einen Prozessor (2) nach einem der vorhergehenden Ansprüche, wobei innerhalb des Luftspeichers (6) und/oder des Kanals (3) zumindest ein elastisches Kompensationselement angeordnet ist, sodass das vom Kühlkörper (1) umschlossene Gesamtvolumen veränderbar ist.

12. System zur Kühlung eines Prozessors (2), aufweisend einen Kühler (10) für einen Prozessor (2) nach einem der vorhergehenden Ansprüche, eine Pumpe (33) und einen Radiator (32), welche über Fluidleitungen (31) fluidisch miteinander verbunden sind, wobei eine Kühlflüssigkeit mittels der zumindest einen Pumpe (33) durch die Fluidleitungen (31), durch den Kanal (3) des Kühlkörpers (1) und durch den Radiator (33) pumpbar ist.

13. System zur Kühlung eines Prozessors (2) nach vorhergehenden Anspruch, aufweisend einen Lüfter (34), der dazu ausgebildet ist, den Radiator (32) zu kühlen, und vorzugsweise am Radiator (32) angeordnet ist.

14. Verfahren zum Betreiben des Kühlers (10) nach einem der Ansprüche 1 bis 11, wobei
der Kühler (10) in eine seiner Einbaulagen ausgerichtet wird (S41),
eine Kühlflüssigkeit durch den Kanal (3) des Kühlers (10) geleitet wird (S42),
Luft und/oder in der Kühlflüssigkeit gelöstes Gas in das Teilvolumen des Luftspeichers (6) abgeschieden wird (S43),
und die Innenkühlfläche (5) in Kontakt mit dem Kühlfluid ist, sodass Wärme entlang der Innenkühlfläche (5) an das Kühlfluid abgegeben wird (S44).

## Claims

1. A cooler (10) for a processor (2), in particular for a CPU or a GPU, comprising
a heat sink (1) with at least one exterior cooling surface (4) for cooling the processor, which is a partial surface of one of the heat sink's outer surfaces,
a duct (3), which runs through the heat sink (1), to convey a coolant, and
a first and a second installation position, the cooler (10) being in a respective specific orientation in relation to the force of gravity (8) in each of the two installation positions,
wherein the duct (3) has at least one interior cooling surface (5) which is formed as a projection of the exterior cooling surface (4) onto the nearest interface between the duct (3) and the heat sink (1),
**characterized in that** the heat sink (1) has at least one air reservoir (6) that is connected to the duct (3),
wherein the air reservoir (6) is arranged outside the projection lines of the interior cooling surface (5) and the exterior cooling surface (4) and is designed such that, in each of the two installation positions, air and/or gas can be separated into at least one subvolume of the air reservoir (6) and the interior cooling surface (5) is in contact with the coolant.

2. A cooler (10) for a processor (2), according to the preceding claim, wherein, in each of the two installation positions, at least a subvolume within the air reservoir (6) is arranged higher in the direction of gravity (8) than at least an area of the duct (3) adjacent to the air reservoir (6).

3. The cooler (10) for a processor (2), according to one of the preceding claims, wherein a cross-section of the duct (3) in the region of the interior cooling surface (5) is smaller than a cross-section of the duct (3) in a directly preceding region in the coolant's direction of flow.

4. The cooler (10) for a processor (2), according to one of the preceding claims, wherein the cooler (10) is orientated in the first installation position such that the at least one exterior cooling surface (4) is perpendicular to the force of gravity (8) and is orientated in the second installation position such that the at least one exterior cooling surface (4) is parallel to the force of gravity (8).

5. The cooler (10) for a processor (2), according to one of the preceding claims, wherein the air reservoir (6) has a first air reservoir segment and a second air reservoir segment which are connected to one another only via the duct (3),
wherein the first air reservoir segment has a first subvolume into which air and/or gas is separable in the first installation position, and
the second air reservoir segment has a second subvolume into which air and/or gas is separable in the second installation position.

6. The cooler (10) for a processor (2), according to one of the preceding claims, wherein the exterior cooling surface (4) has an attachment option for the processor (2).

7. The cooler (10) for a processor (2), according to one of the preceding claims, wherein the cooler (10) comprises two interconnected trays.

8. The cooler (10) for a processor (2), according to one of the preceding claims, wherein the interior cooling surface (5) is flat or has a convex shape.

9. The cooler (10) for a processor (2), according to one of the preceding claims, wherein the at least one air reservoir (6) is designed such that, in each of the two installation positions, at least a subvolume in the air reservoir (6) is arranged higher than any point of the interior cooling surface (5) in the direction of the force of gravity (8).

10. The cooler (10) for a processor (2), according to one of the preceding claims 1 to 8, wherein the at least one air reservoir (6) is designed such that, in at least one installation position, the air reservoir (6) is arranged lower than any point of the interior cooling surface (5) in the direction of gravity (8).

11. The Cooler (10) for a processor (2) according to one of the preceding claims, with at least one elastic compensation element being arranged within the air reservoir (6) and/or the duct (3), thus enabling a change in the total volume enclosed by the heat sink (1).

12. A system for cooling a processor (2), comprising a cooler (10) for a processor (2) according to one of the preceding claims, a pump (33), and a radiator (32), which are fluidically connected to one another via fluid lines (31), wherein a coolant can be pumped through the fluid lines (31), through the duct (3) of the heat sink (1), and through the radiator (33), by way of the at least one pump (33).

13. The system for cooling a processor (2) according to the previous claim, comprising a fan (34) that is designed to cool the radiator (32) and is preferably arranged on the radiator (32).

14. A method for operating the cooler (10) according to one of claims 1 to 11, whereby
the cooler (10) is aligned in one of its installation positions (S41),
a coolant is conveyed through the duct (3) of the cooler (10) (S42),
air and/or gas dissolved in the coolant is separated into the subvolume of the air reservoir (6) (S43),
and the interior cooling surface (5) is in contact with the cooling fluid such that heat is transferred along the interior cooling surface (5) to the cooling fluid (S44).

## Revendications

1. Dispositif de refroidissement (10) pour un processeur (2), en particulier pour une unité centrale de traitement, CPU, ou un processeur graphique, GPU, comprenant
un dissipateur thermique (1) avec au moins une surface de refroidissement externe (4) pour refroidir le processeur, qui est une surface partielle de l'une des surfaces externes du dissipateur thermique,
un canal (3) pour acheminer un fluide de refroidissement, qui traverse l'élément de refroidissement (1), ainsi que
une première et une seconde position d'installation, dans lequel le dispositif de refroidissement (10) présente une orientation spécifique par rapport à la gravité (8) dans chacune des deux positions d'installation,
dans lequel le canal (3) comporte au moins une surface de refroidissement interne (5) qui est conçue comme une projection de la surface de refroidissement externe (4) sur l'interface la plus proche entre le canal (3) et le dissipateur thermique (1),
**caractérisé en ce que** le dissipateur thermique (1) comporte au moins un réservoir d'air (6) qui est relié au canal (3),
dans lequel le réservoir d'air (6) est agencé à l'extérieur des lignes de projection de la surface de refroidissement interne (5) et de la surface de refroidissement externe (4) et est conçu de telle sorte que dans chacune des deux positions d'installation, de l'air et/ou du gaz puissent être séparés dans au moins un volume partiel du réservoir d'air (6) et la surface de refroidissement interne (5) est en contact avec le liquide de refroidissement.

2. Dispositif de refroidissement (10) pour un processeur (2) selon la revendication précédente, dans lequel dans chacune des deux positions d'installation au moins un volume partiel à l'intérieur du réservoir d'air (6) est agencé plus haut dans la direction de la gravité (8) qu'au moins une région du canal (3) adjacente au réservoir d'air (6).

3. Dispositif de refroidissement (10) pour un processeur (2) selon l'une des revendications précédentes, dans lequel une section transversale du canal (3) dans la zone de la surface de refroidissement interne (5) est plus petite qu'une section transversale du canal (3) dans une zone du canal (3) immédiatement en amont dans la direction d'écoulement du liquide de refroidissement.

4. Dispositif de refroidissement (10) pour un processeur (2) selon l'une des revendications précédentes, dans lequel le dispositif de refroidissement (10) est orienté dans la première position d'installation de telle sorte qu'au moins une surface de refroidissement externe (4) soit perpendiculaire à la gravité (8) et dans la seconde position d'installation est orienté de telle sorte qu'au moins une surface de refroidissement externe (4) soit parallèle à la gravité (8).

5. Dispositif de refroidissement (10) pour un processeur (2) selon l'une des revendications précédentes, dans lequel le réservoir d'air (6) comporte un premier segment de réservoir d'air et un second segment de réservoir d'air qui sont reliés l'un à l'autre uniquement par le canal (3),
dans lequel le premier segment de réservoir d'air présente un premier volume partiel dans lequel de l'air et/ou du gaz peuvent être séparés dans la première position d'installation, et
le second segment de réservoir d'air présente un second volume partiel dans lequel de l'air et/ou du gaz peuvent être séparés dans la seconde position d'installation.

6. Dispositif de refroidissement (10) pour un processeur (2) selon l'une des revendications précédentes, dans lequel la surface de refroidissement externe (4) présente une possibilité de fixation pour le processeur (2).

7. Dispositif de refroidissement (10) pour un processeur (2) selon l'une des revendications précédentes, dans lequel le dispositif de refroidissement (10) comporte deux coques interconnectées.

8. Dispositif de refroidissement (10) pour un processeur (2) selon l'une des revendications précédentes, dans lequel la surface de refroidissement interne (5) est réalisée plane ou convexe.

9. Dispositif de refroidissement (10) pour un processeur (2) selon l'une des revendications précédentes, dans lequel au moins un réservoir d'air (6) est conçu de telle sorte que dans chacune des deux positions d'installation au moins un volume partiel à l'intérieur du réservoir d'air (6) soit agencé plus haut dans la direction de la gravité (8) que tout point de la surface de refroidissement interne (5).

10. Dispositif de refroidissement (10) pour un processeur (2) selon l'une des revendications précédentes 1 à 8, dans lequel au moins un réservoir d'air (6) est conçu de telle sorte que dans au moins une position d'installation, le réservoir d'air (6) soit disposé plus bas dans la direction de la gravité (8) que tout point de la surface de refroidissement interne (5).

11. Dispositif de refroidissement (10) pour un processeur (2) selon l'une des revendications précédentes, dans lequel au moins un élément de compensation élastique est agencé dans le réservoir d'air (6) et/ou le canal (3) de sorte que le volume total enfermé par le dissipateur thermique (1) soit variable.

12. Système de refroidissement d'un processeur (2), comprenant un dispositif de refroidissement (10) pour un processeur (2) selon l'une des revendications précédentes, une pompe (33) et un radiateur (32), qui sont reliés fluidiquement l'un à l'autre par des conduites fluidiques (31), dans lequel un fluide de refroidissement peut être pompé à travers les conduites fluidiques (31), à travers le canal (3) du dissipateur thermique (1) et à travers le radiateur (33) au moyen d'au moins une pompe (33).

13. Système de refroidissement d'un processeur (2) selon la revendication précédente, présentant un ventilateur (34) conçu pour refroidir le radiateur (32) et de préférence agencé sur le radiateur (32).

14. Procédé de fonctionnement du dispositif de refroidissement (10) selon l'une des revendications 1 à 11, dans lequel
le dispositif de refroidissement (10) est aligné dans l'une de ses positions d'installation (S41),
un liquide de refroidissement passe par le canal (3) du dispositif de refroidissement (10) (S42),
de l'air et/ou du gaz dissous dans le liquide de refroidissement sont séparés dans le volume partiel du réservoir d'air (6) (S43),
et la surface de refroidissement interne (5) est en contact avec le fluide de refroidissement, de telle sorte que de la chaleur soit transférée le long de la surface de refroidissement interne (5) au fluide de refroidissement (S44).
